(19) 

Europäisches
Patentamt
European
Patent Office
Office européen
des brevets

(11) **EP 1 998 185 A1**

(12) **EUROPEAN PATENT APPLICATION**

(43) Date of publication:
**03.12.2008 Bulletin 2008/49**

(51) Int Cl.:
***G01R 33/50*** *(2006.01)*

(21) Application number: **08103693.1**

(22) Date of filing: **23.04.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **23.04.2007 IT MI20070847**

(71) Applicant: **Stelar S.r.l.**
**27035 Mede (PV) (IT)**

(72) Inventors:
• **CANINA, Davide**
**27100, PAVIA (ITALY) (IT)**

• **SYKORA, Stanislav**
**20022, CASTANO PRIMO (MILANO) (IT)**
• **FERRANTE, Gianni**
**27035, MEDE (PAVIA) (IT)**
• **MARTINI, Giuseppe**
**20135, MILANO (IT)**
• **GOLZI, Paolo**
**20087, ROBECCO SUL NAVIGLIO (MILANO) (IT)**

(74) Representative: **Ponzellini, Gianmarco**
**Bugnion S.p.A.**
**Viale Lancetti 17**
**20158 Milano (IT)**

(54) **Method for nuclear magnetic resonance imaging and relaxometry**

(57) A method has been conceived for acquisition and accumulation of a magnetic resonance signal in the presence of signal instability due to field or frequency instability. After submitting an element to be examined to a suitable experiment, a sequence of pulses for example, for measurement of an echo signal (Hahn-echo experiment), the detected signal for each $\tau$ is broken up into its Cartesian co-ordinates in an IQ plane, the module of the components is calculated and then the calculated modules are added to each other.

By operating on the sum of the calculated modules for each $\tau$ in order to at least partly remove the introduced noise, interpolation of the calculated points can be carried out so as to determine a course representative of the acquired and accumulated parameter as a function of $\tau$.

FIG. 2

EP 1 998 185 A1

**Description**

The present invention relates to a method for acquisition and accumulation of a nuclear magnetic resonance signal (NMR) in the presence of signal instability.

In detail, instability could be due to instability in the magnetic field or in frequency, as better clarified in the following.

The proposed methodology or method is particularly adapted for procedures of acquisition and treatment of NMR signals used for the analysis of the relaxation times, such as $T_1$ or $T_2$ times, in the diffusion measures (NMR relaxometry) and for creation of NMR images (MRI).

One of the great number of possible very advantageous applications of the proposed methodology is linked to calculation of the spin-spin relaxation parameter (or $T_2$ relaxation time) in magnetic resonance processes (NMR) in the presence of field instability and in particular in experiments of field cycling relaxometry.

It is however to be noted that this application is exclusively exemplified in a non-limiting sense, because the methodology can apply in any case and generally for acquisition and accumulation of any nuclear magnetic resonance signal in the presence of instability.

It is known that field cycling relaxometry is a magnetic resonance technique used for determining the longitudinal relaxation times ($T_1$) along a wide range of magnetic field intensity $B_0$ that can vary through about six orders of magnitude from $10^{-6}$ Tesla to about 1 Tesla.

Actually, the limits of this range are not defined in a very precise manner because the lower limit is determined by the local fields, while the upper limit is mainly determined by technical choices and is linked to structural compromises of the analysis device.

At all events, the investigation field of the field cycling relaxometry is much wider than the range presently covered by a standard magnetic resonance that varies from about 0.1 Tesla until about 20 Tesla of magnetic field intensity.

The base experiments of field cycling relaxometry essentially consist of three phases:

1) the sample is polarised in a high-intensity magnetic field $B_d$ over a period of time $t_d$ until the nuclear magnetisation reaches saturation. This phase can be applied as a function of the $B_r$ used;
2) the magnetic field is then brought to an (also zero) value $B_r$ lower than $B_d$ for a certain period of time $t_r$ during which relaxation of the magnetisation towards a new equilibrium value occurs;
3) the magnetic field is brought back to a detection value $B_a$ and the magnetisation equilibrium is measured by sending a 90° pulse to which acquisition of the response follows.

By repeating the phases briefly described above for a given number of time values $t_r$ while keeping $B_r$ constant, parameter $T_1$ relating to field $B_r$ can be determined; during the procedure a different field $B_r$ can be set and measurement of the corresponding new parameter $T_1$ is carried out. In this manner dependence of $T_1$ on the magnetic field is described.

Hereinafter some references to the literature are reproduced:

[1]- L. H. Bryant and G. A. Mercier Jr., Int. J. Mol. Sci. 2, 140 (2001).
[2]- A. Roch and R. N. Muller, J. Chem. Phys. 110, 5403 (1999).
[3]- J. G. Diegel and M. M. Pintar, Biophys. J. 15, 855 (1975).
[4]- D. M. Korzhev, B. G. Karlsson, V. Y. Orekhov and M. Billeter, Protein Sci. 12, 56 (2003).

Since field cycling relaxometry has appeared to be very convenient and, in some ways, a unique method of studying the dynamics of coupled systems for example, such as liquid crystals, polymers, viscous fluids and glasses, a felt requirement is that of being able to calculate not only said $T_1$ parameter, but also $T_2$ parameter, i.e. the spin-spin relaxation time.

However, standard techniques for signal excitation and detection presently used in common magnetic resonance processes for calculation of time $T_2$ have appeared of practically impossible application in Field Cycling NMR, and more generally it has been in addition noticed that the same techniques did not give the expected results also under instable frequency or magnetic field conditions in normal experiments of nuclear magnetic resonance (i.e. not of the Fast Field Cycling).

In particular, if the magnetic field and (frequency) used were sufficiently stable, these measurement procedures could be used; vice versa standard techniques for signal excitation and detection do not generally allow a correct reconstruction and calculation of the desired parameters, of the relaxation times for example.

It is in addition to be noted that stability, above all of the detection magnetic field $B_a$, has an important influence on detection of the different relaxation parameters.

In other words, now a non-perfect field stability does not allow detection of curves of $T_2$ relaxation times in field cycling NMR generally in all situations where measurement is carried out in the presence of a non-sufficiently stable

magnetic field $B_0$ (Zeeman field).

For instance, spin-echo experiments carried out in field cycling magnetic resonance processes for drawing the course of $T_2$ parameters have highlighted the inapplicability of same because the decay relating to the observed "echo time" does not show any regular course from which an estimate of the decay time constant is possible, which constant together with other physical parameters reflects the relaxation time $T_2$.

Accordingly, it is an aim of the present invention to make available a method for detection and accumulation (subsequent signal additions in order to improve signal/noise ratio thereof) of NMR signals in general in the presence of instability and for calculation of the relaxation parameters (relaxation time $T_1$ or also spin-spin or relaxation time $T_2$) in magnetic resonance processes in the presence of instability, for instance in the presence of non (perfectly) homogeneous and (not very) stable fields, in particular in field cycling magnetic resonance processes.

In other words, the main objective of the invention is to make available a method enabling correct acquisition of the NMR signal in order to be able to carry out measurement of a desired parameter under instability conditions.

The foregoing and further aims that will become more apparent in the course of the following description are substantially achieved by the measure method in accordance with the appended claims.

Further features and advantages will be best understood from the detailed description of a preferred but not exclusive embodiment of a method, with the aid of drawings in which:

- Fig. 1 diagrammaticaly shows the course of the applied magnetic fields and the pulses for a spin-echo experiment (Hahn-echo experiment) in Field Cycling in order to carry out the method in accordance with the invention;
- Fig. 2 shows the course of the amplitude of echoes measured at different times (echo times) with a plurality of scanning operations in accordance with the method of the present invention; the accumulated real and imaginary components are highlighted in blue and red, vice versa the accumulated module is highlighted in purple;
- Fig. 3 is a diagram of the correction factor calculated for a set of 32 accumulated acquisitions; the reconstructed signal $S_n$ (in orange) shows a maximum error lower than 1% relative to the real signal.

It is an aim of the present invention to provide a method for acquisition and accumulation of a nuclear magnetic resonance signal (NMR) in the presence of signal instability.

In detail the signal instability can be due to instability of the magnetic field and/or to frequency instability, as better clarified in the following.

The proposed method is particularly adapted in procedures for acquisition and treatment of NMR signals used for analysis of the NMR relaxation times, such as $T_1$ and $T_2$ times, in the diffusion measures (NMR relaxometry) and for creation of NMR images (MRI).

One of the many possible very advantageous applications of the proposed method is connected to calculation of the spin-spin relaxation parameter (or relaxation time $T_2$) in magnetic resonance processes (NMR) in the presence of field instability and in particular in field cycling relaxometry experiments.

It is to be noted however that this application is merely given by way of non-limiting example because the method is applicable in any case and generally for acquisition and accumulation of any NMR signal in the presence of instability.

As said, the method being the object of the invention is particularly applicable in the presence of instable magnetic fields, such as (but not in a limiting sense) the situation occurring during measurement cycles in the presence of low-intensity magnetic fields, i.e. under one Tesla and even until $10^{-6}$ T.

In addition since the acquired (and accumulated) signal is a function of the magnetic field and frequency, it is apparent that said signal will be affected in an equivalent manner either by a field instability or by a frequency instability.

In fact it will be recognised that the relation linking field and frequency is the following:

$$\omega_o = \gamma \, B_0$$

(where $\omega_o$ is Larmor's frequency, $B_0$ the magnetic field and $\gamma$ the gyromagnetic ratio)

Therefore, in the present invention when reference is made to instability situations a field instability or frequency instability is to be intended in an equivalent manner, as pointed out.

In the light of the above, it is quite apparent that the method in accordance with the present invention finds its natural application in field cycling magnetic resonance processes and in all measures carried out under instable field or frequency conditions wherein instability impairs the measure purpose.

In order to make the description of the invention clearer, it is suitable to outline the nuclear magnetic resonance (NMR) technique.

It is known that when a core with a magnetic moment $\mu$ represented by a vector $\mu$ is placed in a static magnetic

field $B_0$ it will have a precession around the $B_0$ direction at a $\omega_0$ frequency, called Larmor's frequency that is proportional to the field intensity ($\omega_o = \gamma B_0$; where $\gamma$ is the gyromagnetic ratio and is different from one core to the other). If a variable magnetic field at a $B_1$ radiofrequency, perpendicular to the $B_0$ field and at the same frequency as the Larmor's frequency is applied, the magnetic moment will have a precession also around $B_1$.

Combination of the two precession motions will cause the magnetic moment $\mu$ to describe a spiral trajectory on the surface of a sphere of $\mu$ radius.

The radiofrequency pulses sent onto the coil to produce the magnetic field have the characteristic that they cause the magnetic moment $\mu$ to rotate through a given angle relative to the $B_0$ direction. This condition is obtained by suitable adjusting the pulse amplitude and duration; the relation linking the $\mu$ torsion angle, that is herein called $\theta$, and the pulse characteristics is $\theta = \lambda B t$ (where B is the pulse amplitude and t the duration of same); each pulse is generally named with the value of the angle the magnetisation of which is rotated; thus such a pulse in which $\theta$ is equal to $\pi/2$ radians will be called $\pi/2$ (or 90°) and such a pulse in which $\theta$ is equal to $\pi$ will be called $\pi$ (or 180°).

Once the radiofrequency pulse has been switched off, the magnetic moment comes back to its starting position with a course described by the characteristic times of this relaxation, referred to as $T_1$, or spin-lattice relaxation time, and as $T_2$, or spin-spin relaxation time.

The NMR technique does not observe a single core, but the combined effect of several cores within the sample of material under examination. Then the magnetisation vector M is defined as the resultant of the sum of all small magnetic moments $\mu$ of the individual atoms; these will have the component parallel to $B_0$.

As pointed out, in order to be able to detect this vector M it is necessary to submit the system or frame to perturbation from its equilibrium state, by applying the second magnetic field $B_1$ perpendicular to $B_0$ for example.

If $B_1$ rotates about $B_0$ at a frequency equal to $\omega_0$, the reference frame being changed and being integral with $B_1$, it is possible to see that vector M has a precession around $B_1$ at an angular frequency $\nu_1$, in this reference frame its orientation being varied relative to the direction of field $B_0$.

At the end of the perturbation due to field $B_1$, the starting equilibrium between the spins of the sample atoms and field $B_0$ is established again with given time modalities. The amplitude of vector M is not maintained during the so-called relaxation process.

It implicates two phenomena: transverse relaxation or annulment of the transverse component $M_{xy}$ and longitudinal relaxation or recovery of the longitudinal magnetisation $M_z$. Evolution of the components of the M(t) vector is described in the rotating reference frame with the phenomenological Bloch equations (herein not reproduced).

The time constant $T_1$ governing return to equilibrium of the longitudinal component of vector M is defined as spin-lattice relaxation time, as it implicates energy transfers taking place between the spin system and the rest of the environment.

The time constant $T_2$ governing annulment of the transverse component of vector M is defined as spin-spin relaxation time, because it implicates the interactions between the magnetic moments of the individual course, i.e. it is linked to the time dynamics leading the atomic spins to lose coherence and therefore to be out of phase or offset.

Should not field $B_0$ be perfectly homogeneous at a local level due to lack of homogeneity of the outer field applied, or due to punctual differences in the system magnetic susceptibility, or for application of a magnetic field characterised by a precise gradient, the precession frequency of the cores also becomes dependent on the position they take relative to these local lack of homogeneity. Each spin pack can then have a precession to a speed of its own in the different points of the sample, being actually offset relative to the others. Therefore a quicker decay of vector M can be seen than the decay that would be expected from the only spin-spin relaxation due to the smaller system order.

At the end of the perturbing action of field $B_1$, after an application time Tp, the return course to equilibrium of the macroscopic magnetisation M tending to become again aligned with field $B_0$ is followed. The signal produced by time variation of vector M is measured in the laboratory using an electromagnetic induction coil placed around the sample in a direction orthogonal to the outer field, which behaves like an antenna; variations in the transverse component of M are linked up with the coil, inducing a small electromotive force therein (that can be measured through a radiofrequency receiver) oscillating at the Larmor's frequency.

The measured signal called FID (Free Induction Decay) fades exponentially with the time as a function of the relaxation constant.

At this point it is to be noted that the greatest effects of the relaxation phenomena (in terms of dependence on the field) are highlighted at relatively low fields where the low-frequency molecular motions can have a very important impact on the times of relaxation, in particular but not exclusively of the longitudinal type.

In the light of the above it is well apparent the reason for which the possibility of calculating the relaxation times $T_1$ and $T_2$ is very important in magnetic resonance processes under instability conditions or in field cycling magnetic resonance processes.

Generally, there are many experiments that can be carried out for being able to subsequently acquire and accumulate an NMR signal, however each experiment involves at least one perturbation phase of the system and a subsequent acquisition phase of the system response to perturbation.

By way of example, reference will be made hereinafter to a suitable type of experiment (Hahn echo) that has been used in experimental tests without however limiting the described methodology to adoption of this experiment.

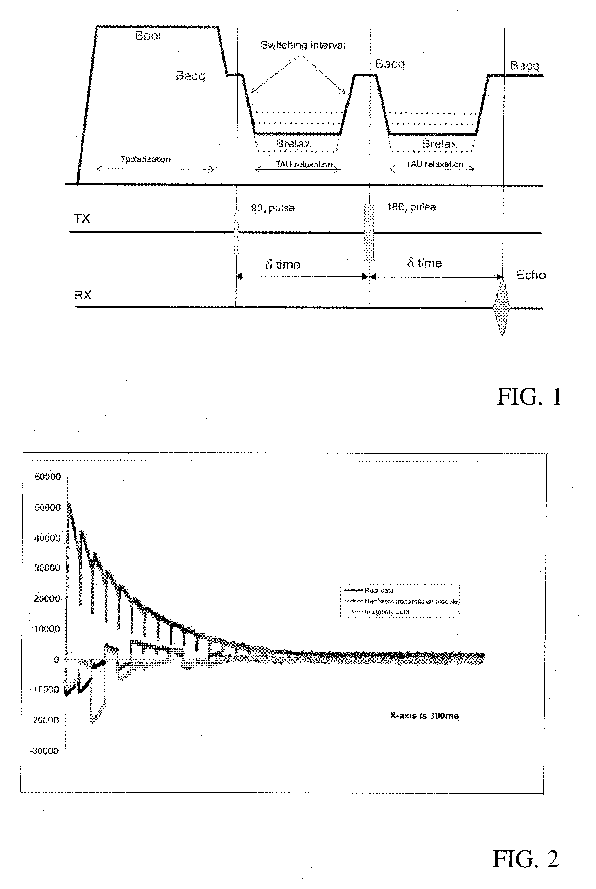

In detail, the preparation procedure for an experiment suitable for calculation of the field cycling magnetic resonance relaxation parameters can comprise the steps illustrated in Fig. 1.

First of all a strong polarisation field $B_{pol}$ is applied for a time long enough to obtain a strong magnetisation $M_0$ aligned with field $B_{pol}$.

The magnet is then suitably controlled so as to bring the magnetic field to a value $B_{relax}$ (which can be also zero) over a certain period of time during which magnetisation decays from value $M_0$ to value $M_r$. After a certain period of predetermined time the magnetic field is brought to its acquisition value $B_{acq}$ and, at the transient end, the measurement sequences of the relaxation parameters can start.

To the aims of calculation of the relaxation parameter, $T_2$ for example, the classic technique said "Hahn-echo" uses a sequence of pulses consisting of a first pulse generally at 90° and a subsequent pulse at 180° emitted after a time $\tau$.

After a further period of time $\tau$ from the second pulse an echo with a peak exactly at time $2\tau$ from the first pulse is generated. In other words, after the initial free-induction signal has disappeared, the second pulse of a value twice the first one at time $\tau$ induces a new response supplying a peak at time $2\tau$; this new response is called "spin-echo".

This type of Hahn-echo technique, although not exclusive and with some modifications, is frequently used for generation of an echo signal exactly used for calculation of the relaxation parameter (particularly $T_2$) in standard magnetic resonance processes.

The echo signal in particular contains information that is directly correlated with the FID and therefore with the relaxation time ($T_1$ or $T_2$).

By way of example only the echo Fourier transform supplies the same frequency spectrum as the FID Fourier transform.

At this point the echo signal detected through the coil is sampled. The signal appears to be broken up at each of the sampling instants into its Cartesian components $i_i$ and $q_i$ in the IQ plane.

In the method in accordance with the invention it is provided that for each sampled i-th point $P_i = I_i + JQ_i$ in the two components I e Q the module $S_i(t) = \left| \sqrt{I_i^2 + Q_i^2} \right.$ be immediately calculated.

The NMR signal that is wished to be observed in a given time interval is sampled in an N point number, each with the necessary sampling period. Each $S_i$ value ("i" going from 1 to N) corresponds to the values of the signal module at a time defined from the beginning of sampling. N values of $S_i$ represent the signal module in the defined time scale. In order to increase the signal/noise (or S/N) ratio, the experiment is repeated many times under the same conditions. In each experiment, each i-th point of the signal is acquired and defined into components $I_i$, $Q_i$ and $M_i$ (module; coincident with $S_i$). The M values can be acquired and/or directly calculated from the corresponding I and Q values in each individual point or at the end of each individual experiment on the whole set of I and Q values.

The values of the signal components are accumulated with the corresponding values obtained in the preceding experiments. The module signals M directly acquired or calculated from the I and Q values in the above described manner are continuously accumulated. To enable signal accumulation in a coherent manner, in the subsequent experiments the $S_i$ values will be added to the sum of the preceding values.

In other words, the steps of calculating the component module and adding the previously calculated modules to each other are carried out for each sampled point, the accumulated module through the I and Q accumulated signal being not calculated, i.e. not like

$$|S| = \left| \sum_{i=1}^{n} Ii + j \sum_{i=1}^{n} Qi \right|$$

but the module of the accumulated signal in n experiments being calculated by the method:

$$|S| = \sum_{1=1}^{n} |Ii + jQi|$$

The accumulated values reflect the amplitude of the signal, irrespective of the magnetic field value (or Larmor's frequency) by which it was acquired (irrespective of the instability, of the magnetic field for example).

In this regard Fig. 2 shows the accumulated real and imaginary values, in blue and green respectively. From the representation it is immediately clear that the decay is destroyed by the field instability when accumulated in Cartesian co-ordinates.

On the contrary, the purple line shows the module of the accumulated signal in the different n experiments according to the relation

$$|S| = \sum_{i=1}^{n} |Ii + jQi|$$

showing a good decay, irrespective of instability.

By this method the experiment can be repeated with different values of echo time $\tau$ and the signal amplitude can therefore be acquired as a function of $\tau$. The course of the echo amplitude relative to $\tau$ depends on the relaxation parameter ($T_2$, for example).

In addition, it is to be noted that, in order to determine the course of the relaxation time as a function of intervals t, the above operations, i.e. the echo experiment and subsequent signal processing, are carried out with reference to a plurality of distinct $\tau$, in accordance with predetermined optimised sequences.

In this manner the course of the desired NMR parameter (the relaxation times, for example) can be graphically obtained as a function of $\tau$ (Fig. 2 - purple line).

Acquisition and accumulation of the signal in the above described manner however involves introduction of errors and value offsets on the results due to accumulation of the noise module that could lead to errors in calculating the NMR parameter, in the calculation of the relaxation parameter for example, be it $T_1(\tau)$ or $T_2(\tau)$.

$$S_n(t) = \sqrt{I_n^2(t) + Q_n^2(t)} = \sqrt{S^2(t) + n_I^2(t) + n_Q^2(t) + 2(I(t)n_I(t) + Q(t)n_Q(t))}$$

where :

$$I_n(t) = I(t) + n_I(t)$$

$$Q_n(t) = Q(t) + n_Q(t)$$

The above equation highlights the fact that to each detection of signal $S_n(t)$, noise n(t) is introduced (Gaussian noise at zero average).

In particular, the square terms of n are always positive and are added to the signal under any situation. It is apparent that the noise effect appears to be more important under conditions of very low signal/noise (S/N) ratio. In fact, under each condition but in particular with low S/N ratios, signal $S_n(t)$ will tend to be greater than its real value S(t).

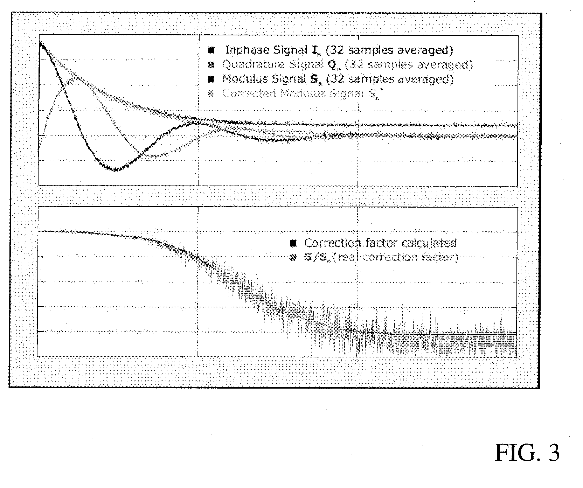

In particular, the noise effects are apparent in the low region of the calculated FID curve (Fig. 3 - red curve) where the signal/noise ratio is generally worse. Intervention is necessary in order to obviate this situation. Measure errors can be corrected during the acquisition step by a suitable measure sequence.

Correction can be carried out during the subsequent processing by correcting the values of the acquired data with suitable coefficients and/or algorithms directly intervening on each point defined by the sum of modules.

The above can be carried out in detail with good results by the suitable mathematical algorithm reproduced herebelow.

It is obviously understood that other algorithms could be efficiently used as an alternative to the proposed one.

Being stated that the course of signal $S_{n,i}$ is calculated for each $I_{n,i}$ and $Q_{n,i}$ sampling, through the above mentioned equation reproduced below for reference,

$$S_n(t)=\sqrt{I_n^2(t)+Q_n^2(t)}=\left[S^2(t)+n_I^2(t)+n_Q^2(t)+2(I_1(t)n_I(t)+Q_1(t)n_Q(t))\right]^{1/2}$$

an average on k samplings is then calculated

$$\overline{S}_n = \frac{\sum\limits_{i=1}^{k} S_{n,i}}{k}$$

The module calculated following the method in accordance with the invention is therefore affected by a systematic error linked to the square terms of the noise (rectified noise).

$\overline{S}_n(t)$ can be seen as an estimator of the average of the stochastic process $S_n(t)$, which has the Rice probability. The average (assembly of averages to a predetermined t) of $S_n(t)$ is the following:

wherein in particular

$$\overline{S}_n(t) = E\{S_n(t)\} = \left(\frac{\pi\cdot\sigma^2}{2}\right)^{\frac{1}{2}} \cdot e^{-\frac{x}{2}} \cdot \left[(1+x)\cdot I_0\cdot\frac{x}{2}+x\cdot I_1\cdot\frac{x}{2}\right]$$

$$x = \frac{S^2(t)}{2\cdot\sigma^2}$$

corresponds to half the signal/noise ratio

$$SNR = \frac{E\{S^2(t)\}}{\sigma^2}$$

In detail, $I_0$ and $I_1$ are the modified Bessel's functions of the first order.

Under this situation, knowledge of the noise power $\sigma^2$ allows reversal of the above algorithm and a correct estimate of the module of signal S from the measured module $\overline{S}_n(t)$ according to the following procedure:

1) calculation of $\overline{S}_n(t)$ according to the reproduced formula;
2) measurement of the noise power $\sigma^2$;
3) calculation of the estimated value of S through reversal of the algorithm.

It is to be noted that reversal can be carried out following different methods: approximations with series developments, recursive methods, use of reversal tables, etc.

It is also to be pointed out that steps 1 and 2 can be carried out following any time sequence.

The invention achieves important advantages.

In fact, the above method allows an NMR signal to be acquired and accumulated under instability conditions and consequently the relaxation parameters $T_1$ and/or $T_2$ to be determined, and also enables exploitation of the signal amplitudes for construction of an NMR image (also with a non sufficiently stable magnetic field for reaching the result that the experiment aims at). This method can be in particular applied also (although not only) where for measurement the field cycling magnetic resonance is used.

In this particular situation, the set out method allows the $T_2$ parameter and the dynamics of same at low magnetic fields to be analysed by the field cycling technique and the accuracy in determining the $T_1$ parameter to be greatly improved. This information cannot be obtained with other traditional techniques and not at all with instable magnetic fields. As to possible industrial applications of the above described relaxometry technique, it is possible to mention application in the magnetic resonance by images where $T_2$ images at different magnetic fields could be constructed by the field cycling relaxometry technique, by exploiting the possibility of highlighting by contrast the regions in which $T_2$ values change. Also to be mentioned are porous materials where wettability and permeability of these materials can be determined, as well as the pore sizes or the internal localisation of liquids.

With reference to polymeric materials the relaxometry techniques allow characterisation of natural rubbers or also identification of the properties of polymeric blends.

Among the great number of application fields also to be mentioned is the food field where the relaxometry techniques are used for determining distribution of components within a food such as fats in meat, cheese, etc., or water contents in the products.

The method is also advantageous in the contrast media for MRI where comprehension of $T_2$ behaviour with the magnetic field can supply important information on the compound dynamics.

**Claims**

1. A method for the acquisition and accumulation of an NMR signal in the presence of instability, comprising the following steps:

   - submitting an element to be examined to a magnetic perturbation;
   - acquiring an NMR signal subsequently to the imposed perturbation;
   - breaking up each sampled point of the signal into its Cartesian components $i_i$ and $q_i$ in an IQ plane, **characterised in that** it further comprises the following steps:
   - calculating the module of the Cartesian components and storing the course of the signal (FID or echo, for example) as a succession of values corresponding to the module of the i-th sampled points

$$S_i(t) = \left| \sqrt{i_i^2 + q_i^2} \right| ;$$

   - accumulating the NMR signal of subsequent experiments by adding the time-corresponding values of the module of each sampled point.

2. A method of acquisition and accumulation of an NMR signal in the presence of an instable NMR signal due to instable magnetic field, in particular not sufficiently stable to enable the experiment to be carried out with traditional methods, according to the preceding claim, particularly for calculation of the spin-spin and spin-lattice relaxation parameter in magnetic resonance processes, such as processes of Fast Field Cycling NMR.

3. A method as claimed in anyone of the preceding claims, **characterised in that** the step of submitting an element to a perturbation comprises:

   - submitting an element to be examined to a first stationary magnetic field $B_0$;
   - applying a first pulse, preferably at 90°, to the element to be examined;
   - waiting for a predetermined time $\tau$;
   - applying a second pulse of twice the intensity of the preceding one, preferably at 180°, to the element to be examined; the acquisition step comprising:
   - detecting an echo signal after a period of time of about $2\tau$ from application of the first pulse.

4. A method as claimed in claim 1, **characterised in that** the perturbation and acquisition steps are carried out a plurality of times, the experiment conditions being the same, in particular application of a first pulse, possible application of a second pulse and detection are carried out a plurality of times by varying $\tau$ according to a predetermined sequence.

5. A method as claimed in claim 1, **characterised in that** the steps of breaking up the signal, calculating the module of the components and accumulating the previously calculate modules, are carried out for each sampled point, the module accumulated through the I and Q accumulated signal being not calculated, i.e. not like

$$|S| = \left| \sum_{i=1}^{n} Ii + j \sum_{i=1}^{n} Qi \right|$$

but the module of the signal accumulated in n experiments being calculated by the method:

$$|S| = \sum_{1=1}^{n} |Ii + jQi|$$

6. A method as claimed in claim 1, **characterised in that** it further comprises a step of carrying out interpolation of the calculated points for determining a decreasing course of the exponential type of the relaxation parameter as a function of $\tau$, the relaxation parameter $T_2$ for example.

7. A method as claimed in claim 1, **characterised in that** it further comprises a step of operating on the sum of the calculated modules for each $\tau$ in order to at least partly remove an introduced noise.

8. A method as claimed in anyone of the preceding claims, **characterised in that** the steps of breaking up the signal, calculating the module of the components and accumulating the previously calculated modules, are carried out for each sampled point, through calculation of the module of the accumulated average signal in n experiments by the method:

$$\overline{S}_n = \frac{\sum\limits_{i=1}^{k} S_{n,i}}{k}$$

9. A method as claimed in the preceding claim, **characterised in that** it further comprises a step of removing the systematic noise introduced into calculation of the signal by a suitable mathematical removal algorithm.

10. A method as claimed in the preceding claim, **characterised in that** the mathematical algorithm for noise removal answers the notation:

$$\overline{S}_n(t) = E\{S_n(t)\} = \left(\frac{\pi \cdot \sigma^2}{2}\right)^{\frac{1}{2}} \cdot e^{-\frac{x}{2}} \cdot \left[(1+x) \cdot I_0 \cdot \frac{x}{2} + x \cdot I_1 \cdot \frac{x}{2}\right]$$

wherein

$$x = \frac{S^2(t)}{2 \cdot \sigma^2}$$

and $\sigma^2$ being the noise power.

11. A method as claimed in claim 10, **characterised in that** it further comprises the step of carrying out detection on the sample to be examined in the absence of signal for determining a noise power $\sigma^2$.

**12.** A method as claimed in claim 10, **characterised in that** it comprises the steps of calculating the module of the accumulated average signal

$$\overline{S}_n(t),$$

for calculation of the noise power $\sigma^2$ and calculation of the value of the accumulated signal S by reversal of the noise removal algorithm

$$E\{S_n(t)\}.$$

FIG. 1

FIG. 2

FIG. 3

**European Patent Office**

**EUROPEAN SEARCH REPORT**

Application Number

EP 08 10 3693

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CANINA D. ET AL: "Novel Approaches to Signal Acquisitions and Accumulation in FFC-NMR experiments, Poster presented at the 4th Conference on Field Cycling NMR Relaxometry"[Online] 26 May 2005 (2005-05-26), - 28 May 2005 (2005-05-28) XP002492160 Torino, Italy, Retrieved from the Internet: URL:http://www.ebyte.it/stan/Poster_SpinWh ipAcquisition.html> [retrieved on 2008-08-13] | 1-6,8 | INV. G01R33/50 |
| Y | * the whole document * | 7,9-12 | |
| Y | HENKELMAN R M: "Measurement of signal intensities in the presence of noise in MR images" MEDICAL PHYSICS USA, vol. 12, no. 2, March 1985 (1985-03), pages 232-233, XP002492161 ISSN: 0094-2405 * the whole document * | 7,9-12 | |
| | | | TECHNICAL FIELDS SEARCHED (IPC) |
| | | | G01R |
| P,X | FERRANTE G. ET AL: "Measurement of spin-spin relaxation time T2 at very low magnetic field by means of the Fast Field Cycling NMR method, Poster presented at the 48th ENC Conference"[Online] 23 April 2007 (2007-04-23), XP002492162 Dayton Beach, FL (USA) Retrieved from the Internet: URL:http://www.ebyte.it/stan/Poster_FFC_T2 .html> [retrieved on 2008-08-13] * the whole document * | 1-6,8 | |

-/--

The present search report has been drawn up for all claims

| Place of search | Date of completion of the search | Examiner |
|---|---|---|
| Munich | 14 August 2008 | Skalla, Jörg |

EPO FORM 1503 03.82 (P04C01)

**European Patent Office**

## EUROPEAN SEARCH REPORT

Application Number

EP 08 10 3693

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SIJBERS J ET AL: "Estimation of the noise in magnitude MR images" MAGNETIC RESONANCE IMAGING ELSEVIER USA, vol. 16, no. 1, January 1998 (1998-01), pages 87-90, XP002492163 ISSN: 0730-725X * the whole document * | 1,7,9-12 | |
| A | BONNY J -M ET AL: "T2 maximum likelihood estimation from multiple spin-echo magnitude images" MAGNETIC RESONANCE IN MEDICINE WILLIAMS & WILKINS USA, vol. 36, no. 2, August 1996 (1996-08), pages 287-293, XP002492164 ISSN: 0740-3194 * page 287 * | 1,7,9-12 | |
| A | GUDBJARTSSON H ET AL: "The Rician distribution of noisy MRI data" MAGNETIC RESONANCE IN MEDICINE USA, vol. 34, no. 6, December 1995 (1995-12), pages 910-914, XP002492283 ISSN: 0740-3194 * the whole document * | 1,7,9-12 | TECHNICAL FIELDS SEARCHED (IPC) |

The present search report has been drawn up for all claims

| Place of search | Date of completion of the search | Examiner |
|---|---|---|
| Munich | 14 August 2008 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L. H. BRYANT ; G. A. MERCIER JR.** *Int. J. Mol. Sci.,* 2001, vol. 2, 140
- **A. ROCH ; R. N. MULLER.** *J. Chem. Phys.,* 1999, vol. 110, 5403
- **J. G. DIEGEL ; M. M. PINTAR.** *Biophys. J.,* 1975, vol. 15, 855
- **D. M. KORZHEV ; B. G. KARLSSON ; V. Y. OREKHOV ; M. BILLETER.** *Protein Sci.,* 2003, vol. 12, 56